# EUROPEAN PATENT APPLICATION

(11) **EP 4 696 728 A1**
(43) Date of publication of application: **18.02.2026**
(21) Application number: 24877540.5
(22) Date of filing: 11.10.2024
(51) Int. Cl.: C08F 290/06, C08F 279/02, C08F 222/40, C08F 2/44, C08K 3/013, C08K 3/36, C08J 5/18, H05K 1/03, C08L 71/12, C08L 9/06

(54) **CURABLE RESIN COMPOSITION, AND INSULATING FILM AND PRINTED CIRCUIT BOARD COMPRISING SAME**

(30) Priority: 12.10.2023 KR 20230135574; 02.10.2024 KR 20240134157
(71) Applicant: LG Chem, Ltd., Seoul 07336 (KR)
(72) Inventor: KIM, Bokyung, Daejeon 34122 (KR); PARK, Jun Wuk, Daejeon 34122 (KR); YOON, Youngsik, Daejeon 34122 (KR)
(74) Representative: Hoffmann Eitle
(86) International application number: PCT/KR2024/015377
(87) International publication number: WO 2025/080004

(57) **Abstract**

Provided is a curable resin composition comprising: a maleimide compound comprising a diphenylmethane structure; a radical polymerizable resin; a high-molecular weight resin comprising a conjugated diene structure; and an inorganic filler, wherein the inorganic filler is comprised in an amount of 200 parts by mass or more and 400 parts by mass or less based on 100 parts by mass of the entire solid content of the maleimide compound comprising a diphenylmethane structure; the radical polymerizable resin; and the high-molecular weight resin comprising a conjugated diene structure, and accordingly, a low coefficient of thermal expansion, an ultra-low dissipation factor, and improved brittleness may be secured.

## Description

### TECHNICAL FIELD

The present specification relates to a curable resin composition, and an insulating film and a printed circuit board including the same.

This application claims priority to and the benefit of Korean Patent Application No. 10-2023-0135574 filed in the Korean Intellectual Property Office on October 12, 2023, and Korean Patent Application No. 10-2024-0134157 filed in the Korean Intellectual Property Office on October 2, 2024.

### BACKGROUND ART

A printed circuit board (PCB) means, as a support for electronic components, a board in which the electronic components are fixed to the surface of a printed wiring board and the components are connected with copper wiring to form an electronic circuit.

Generally, the printed circuit board is based on the formation of multiple layers by insulating connection between copper wirings. In order to increase the reliability of the board, methods of improving the adhesive strength between an insulating layer and a copper foil layer, such as methods of including in the insulating layer a component that has a high bonding strength with Cu, or of forming surface roughness on the surface of the insulating layer to increase the surface area of the interface have been proposed.

As a method for manufacturing a multi-layer printed circuit board, a method has been publicly known in which a prepreg sheet is used to stack layers on an inner layer circuit board on which a copper foil circuit is formed, and interlayer connection is performed by through-holes, but this method requires large-scale installations, is highly costly and time-consuming, and has problems in that it is difficult to form fine patterns.

As a method of solving the above problems, a method for manufacturing a multi-layer printed circuit board in combination with a build-up method has been recently proposed. The build-up method is a technology for alternately stacking conductor layers and organic insulating layers (or insulating films) of a circuit board, and includes the steps of full curing, drilling, roughening treatment, electroless plating, electrolytic plating, postcuring, and outer layer circuit formation after vacuum lamination of the insulating films.

Although epoxy resins and phenol-based curing agents have been used as curable resin compositions for an insulating film in the related art, epoxy resins and cyanate ester-based curing agents or active ester-based curing agents are used as curable resin compositions for an insulating film while there is a need for low dispassion factor in order to transmit signals at high speed.

Recently, as the need for a low dissipation factor has become more stringent, there is a tendency to add a maleimide compound to a curable resin composition for an insulating film having high heat resistance and low dielectric characteristics.

However, another material used in the curable resin composition for an insulating film, an epoxy resin, exhibits a dissipation factor exceeding 0.005 based on 10 GHz, so there is a limitation in achieving an ultra-low dissipation factor.

Furthermore, due to the characteristics in which the maleimide compound, which is a key substance for achieving a low dissipation factor, has a high softening point, the cured product of the maleimide-containing curable resin composition tends to be brittle. In order to solve these problems, attempts have been made to add a thermoplastic resin such as a phenoxy resin, but there is a disadvantage of causing thermal deformation during the process due to a high coefficient of linear thermal expansion.

Therefore, there is a need for further research into a curable resin composition.

### SUMMARY OF THE INVENTION

### TECHNICAL PROBLEM

The present invention has been made in an effort to provide a curable resin composition, and an insulating film and a printed circuit board including the same.

### TECHNICAL SOLUTION

The present inventors have found that the combination of a maleimide compound comprising a diphenylmethane structure, a radical polymerizable resin, a high-molecular weight resin comprising a conjugated diene structure and an inorganic filler having a specific content range solves the problems of existing curable resin compositions, and can exhibit a low coefficient of linear thermal expansion and improved brittleness together with ultra-low dissipation factor. The curable resin composition according to the present invention is characterized by not including an epoxy resin while being capable of self-initiation, and can achieve a low dissipation factor in order to transmit signals at high speed.

Therefore, based on the above characteristics, exemplary embodiments of the present invention are as follows.

An exemplary embodiment of the present invention provides a curable resin composition including: a maleimide compound including a diphenylmethane structure; a radical polymerizable resin; a high-molecular weight resin including a conjugated diene structure; and an inorganic filler, in which the inorganic filler is included in an amount of 200 parts by mass or more and 400 parts by mass or less based on 100 parts by mass of the entire solid content of the maleimide compound including a diphenylmethane structure; the radical polymerizable resin; and the high-molecular weight resin including a conjugated diene structure.

Another exemplary embodiment provides an insulating film including the above-described curable resin composition or a cured product thereof.

Yet another exemplary embodiment provides a printed circuit board including the above-described insulating film.

### ADVANTAGEOUS EFFECTS

The curable resin composition according to the present specification has a low coefficient of linear thermal expansion, and thus, can prevent cracks in the reliability tests of insulating films in the future.

The curable resin composition according to the present specification has high peel strength in terms of the insulating film in the future, and thus, can provide excellent copper foil adhesion.

In particular, the curable resin composition according to the present specification can provide an advantage in that a decrease in peel strength is prevented under the conditions of a high content of inorganic filler.

### BRIEF DESCRIPTION OF THE DRAWINGS

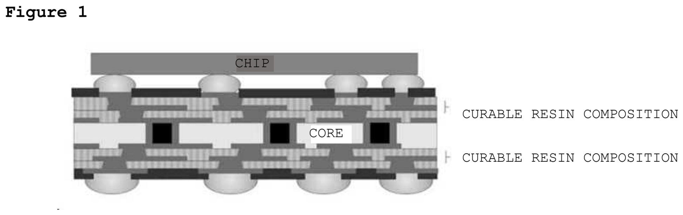

FIG. 1 schematically illustrates an example of the use of a curable resin composition according to an exemplary embodiment of the present specification.

### DETAILED DESCRIPTION

Hereinafter, the present specification will be described in more detail.

When one member is disposed "on" another member in the present specification, this includes not only a case where the one member is brought into contact with another member, but also a case where still another member is present between the two members.

When one part "includes" one constituent element in the present specification, unless otherwise specifically described, this does not mean that another constituent element is excluded, but means that another constituent element may be further included.

In the present specification, the "polymer" means a compound composed of the repetition of repeating units (basic units). The polymer may be referred to as a macromolecule (polymer) or a compound composed of macromolecules, and the polymer may have one or more repeating units.

### <Curable resin composition>

Hereinafter, a curable resin composition according to an exemplary embodiment of the present specification will be described.

The curable resin composition according to an exemplary embodiment of the present specification includes a maleimide compound including a diphenylmethane structure, a radical polymerizable resin, a high-molecular weight resin including a conjugated diene structure, and an inorganic filler, in which the inorganic filler is included in an amount of 200 parts by mass or more and 400 parts by mass or less based on 100 parts by mass of the entire solid content of the maleimide compound including a diphenylmethane structure; the radical polymerizable resin; and the high-molecular weight resin including a conjugated diene structure.

In the present specification, 'solid content' may also be expressed as 'non-volatile content,' and means that the measurement is performed by methods known in the art.

In an exemplary embodiment of the present invention, the content of the inorganic filler may be 200 parts by mass or more, and 400 parts by mass or less, 390 parts by mass or less, 380 parts by mass or less, 370 parts by mass or less, 350 parts by mass or less, 340 parts by mass or less, 330 parts by mass or less, 320 parts by mass or less, 310 parts by mass or less, or 300 parts by mass or less, based on 100 parts by mass of the entire solid content of the maleimide compound including a diphenylmethane structure, the radical polymerizable resin, and the high-molecular weight resin including a conjugated diene structure.

The curable resin composition includes four components, and among them, when the content of the inorganic filler is within the above range, a low coefficient of linear thermal expansion of 25 ppm/°C or less and an ultra-low dissipation factor of 0.003 or less may be achieved, and the improvement of brittleness may be implemented.

In particular, when the content of the inorganic filler is less than 200 parts by mass based on 100 parts by mass of the entire solid content of the maleimide compound including a diphenylmethane structure, the radical polymerizable resin, and the high-molecular weight resin including a conjugated diene structure, the coefficient of thermal expansion may be higher than the desired range, and when the content exceeds 400 parts by mass, the brittleness may be increased.

Referring to FIG. 1, an example of the use of a curable resin composition according to an exemplary embodiment of the present specification is illustrated. Specifically, FIG. 1 illustrates a multi-layer printed circuit board in combination with a build-up method, in which an insulating layer (or insulating film) includes a curable resin composition according to an exemplary embodiment of the present specification.

According to an exemplary embodiment of the present specification, the maleimide compound including a diphenylmethane structure may be represented by the following Chemical Formula 1.

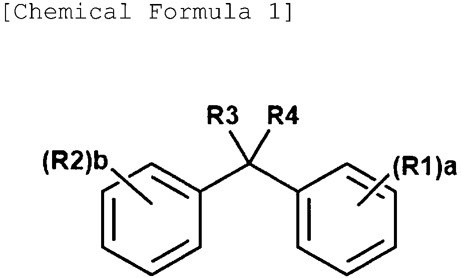

In Chemical Formula 1,
R1 to R4 are the same as or different from each other, and are each independently hydrogen; an alkyl group; an aryl group; a heteroaryl group; or a substituent represented by the following Chemical Formula 2, and at least one thereof is a substituent represented by the following Chemical Formula 2,
a and b are the same as or different from each other, and are each independently an integer from 0 to 5, and when each of a and b is an integer of 2 or higher, substituents in the parenthesis are the same as or different from each other, 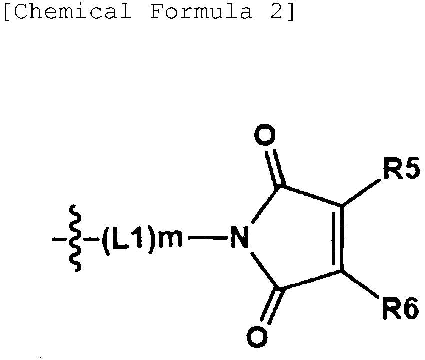 in Chemical Formula 2, 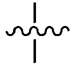
   means a bond to Chemical Formula 1,
   L1 is a direct bond; an alkylene group; an arylene group; or a heteroarylene group,
   R5 and R6 are the same as or different from each other, and are each independently hydrogen; an alkyl group; an aryl group; or a heteroaryl group, and
   m is an integer from 0 to 4.

Chemical Formula 1 is a diphenylmethane structure, and Chemical Formula 2 means a maleimide compound.

When the maleimide compound including the diphenylmethane structure as described above is used in an insulating film, it is possible to have an ultra-low dissipation factor as well as improved brittleness.

In an exemplary embodiment of the present invention, the content of the maleimide compound including a diphenylmethane structure may be 1% by mass or more, 2% by mass or more, or 3% by mass or more, and 20% by mass or less, 19% by mass or less, or 18% by mass or less, based on 100% by mass of the solid content of the curable resin composition.

When the content is satisfied as described above, it is possible to further improve brittleness as well as to obtain an ultra-low dissipation factor.

In an exemplary embodiment of the present invention, the maleimide including a diphenylmethane structure is not particularly limited as long as it satisfies the structure of Chemical Formula 1, but examples thereof may include BMI-5100, BMI-2300 (Daiwakasei Industry Co., Ltd.), and the like, and one type may be used alone or two or more types may be used in combination, if necessary.

According to an exemplary embodiment of the present specification, the radical polymerizable resin includes an unsaturated group, and the unsaturated group may be selected from the group consisting of a (meth)acrylate group, a (meth)acrylamide group, salts of organic acids, a vinyl ether group, an allyl ether group, a vinyl ester group, a styrene group, a vinyl group, and an allyl ester group, but is not particularly limited as long as it does not deviate from the spirit of the present invention and is publicly known in the art.

Examples of the radical polymerizable resin may include the OPE-2St series (Mitsubishi Gas Chemical Company, Inc.), and the like, and one type may be used alone or two or more types may be used in combination, if necessary.

In an exemplary embodiment of the present invention, the content of the radical polymerizable resin may be 10% by mass or more, 11% by mass or more, or 12% by mass or more and 30% by mass or less, 29% by mass or less, or 28% by mass or less, based on 100% by mass of the solid content of the curable resin composition.

When the content is satisfied as described above, polymerization is facilitated and other properties required for the curable resin composition may be additionally obtained.

According to an exemplary embodiment of the present specification, the high-molecular weight resin including a conjugated diene structure may include a unit represented by the following Chemical Formula 3 in at least one of a main chain and a side chain.

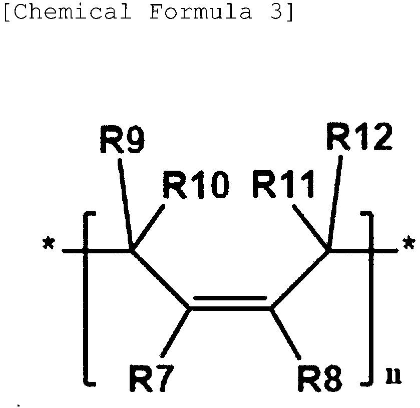

In Chemical Formula 3,
* is a position linked to another unit,
R7 to R12 are the same as or different from each other, and are each independently hydrogen; an alkyl group; an aryl group; or a heteroaryl group, and
n is 90 or more and 4000 or less.

When the high-molecular weight resin having the structure as described above is used in an insulating film, a cured product having improved brittleness and excellent dielectric characteristics may be obtained.

In an exemplary embodiment of the present invention, the content of the high-molecular weight resin including a conjugated diene structure may be 1% by mass or more, 2% by mass or more, or 3% by mass or more, and 20% by mass or less, 19% by mass or less, or 18% by mass or less, based on 100% by mass of the solid content of the curable resin composition.

When the content as described above is satisfied, a cured product having improved brittleness and excellent dielectric characteristics may be obtained.

According to an exemplary embodiment of the present specification, the high-molecular weight resin including a conjugated diene structure includes a polybutadiene resin, a styrene-butadiene resin, a styrene-butadiene-styrene resin, a styrene-ethylene-butylene-styrene resin, a styrene-butadiene-butylene-styrene resin, and the like, but is not limited thereto as long as it does not depart from the scope of the present invention.

According to an exemplary embodiment of the present specification, the high-molecular weight resin including a conjugated diene structure may have a weight average molecular weight (MW) of 4,000 g/mol or more and 200,000 g/mol or less.

When the weight average molecular weight (MW) of the high-molecular weight resin including a conjugated diene structure is less than 4,000 g/mol, it is difficult to handle the resin and the brittleness tends to deteriorate because the viscosity is low, and when the weight average molecular weight (MW) exceeds 200,000 g/mol, it may be difficult to perform a process of producing a film because the viscosity is high.

In the present specification, the weight average molecular weight may be measured by a gel permeation chromatography (GPC) method (polystyrene equivalent).

According to an exemplary embodiment of the present specification, the inorganic filler may have an average particle diameter of 1.0 µm or less, preferably 0.7 µm or less, more preferably 0.5 µm or less, and 0.1 µm or more, 0.2 µm or more, or 0.3 µm or more.

According to the exemplary embodiments, when the average particle diameter of the inorganic filler exceeds 1.0 um, the surface roughness becomes large, so that undesired loss of signals due to noise and precipitation occur, which may result in poor uniformity, and when the average particle diameter of the inorganic filler is less than 0.1 µm, the minimum melt viscosity is excessively high, exceeding 20,000 cP in a temperature range of 70°C to 150°C, so that processability may deteriorate due to reduced fluidity.

According to an exemplary embodiment of the present specification, the inorganic filler may be surface-treated with a surface treatment agent such as a coupling agent.

According to an exemplary embodiment of the present specification, the inorganic filler may be silica, silicate, barium sulfate, alumina, and the like, but is not limited thereto.

In the present specification, the silica may be, for example, spherical silica, fused silica, hollow silica, crystalline silica, amorphous silica, and the like, but is not limited thereto, but SOC1, SOC2 (Admatechs), and the like are commercially available.

According to an exemplary embodiment of the present specification, the curable resin composition may further include at least one of a thermosetting resin; and a thermoplastic resin.

In the present specification, the thermosetting resin is a substance that is cured by applying heat and then has a shape that remains unchanged when heated again, and is not particularly limited to those publicly known in the art. If necessary, one type of thermosetting resin may be used alone, or two or more types may be used in combination, and the content can be appropriately changed as long as it does not depart from the scope of the present invention.

In the present specification, the thermoplastic resin is a substance that is cured by applying heat and then has a shape that changes when heated again, and is not particularly limited to those publicly known in the art. If necessary, one type of thermoplastic resin may be used alone, or two or more types may be used in combination, and the content can be appropriately changed as long as it does not depart from the scope of the present invention.

The curable resin composition according to an exemplary embodiment of the present invention further includes an additive and a solvent, and the additive may be selected from the group consisting of a leveling agent, a wetting agent, an antistatic agent, a flame retardant, a crosslinking agent, a curing accelerator, a curing agent, and a polymerization initiator.

In the present specification, the leveling agent is a substance that controls flowability when a curable resin composition is used in the future to prevent defects such as craters when applied to a surface in the future, and examples of the leveling agent that is publicly known in the art include BYK 350, BYK 354, BYK 356, BYK 359, BYK399, and the like, but are not particularly limited thereto. In some cases, one type of the leveling agent may be used alone or two or more thereof may be used in mixture, and the content can be appropriately changed as long as it does not depart from the scope of the present invention.

In the present specification, the wetting agent is a substance that accelerates wetting and helps the inorganic filler to aggregate, and is not particularly limited to those publicly known in the art. If necessary, one type of wetting agent may be used alone, or two or more types thereof may be used in combination, and the content can be appropriately changed as long as it does not depart from the scope of the present invention.

In the present specification, the antistatic agent is a substance that imparts an antistatic effect, and is not particularly limited to those publicly known in the art. If necessary, one type of antistatic agent may be used alone, or two or more types thereof may be used in combination, and the content can be appropriately changed as long as it does not depart from the scope of the present invention.

In the present specification, the flame retardant is a substance that reduces flammability or retards combustion, and is not limited to those publicly known in the art. If necessary, one type of flame retardant may be used alone, or two or more types thereof may be used in combination, and the content can be appropriately changed as long as it does not depart from the scope of the present invention.

In the present specification, the crosslinking agent is a substance that forms a crosslinked bond between polymers, and examples of the crosslinking agent publicly known in the art include TAIC, DAIC (allyl-based), ALP-d (benzoxazine-based), and the like, but are not particularly limited thereto. If necessary, one type of crosslinking agent may be used alone, or two or more types thereof may be used in combination, and the content can be appropriately changed as long as it does not depart from the scope of the present invention.

In the present specification, the curing accelerator is a substance that shortens the curing time, and is classified into a phosphorus-based curing accelerator, an amine-based curing accelerator, an imidazole-based curing accelerator, and the like, which are publicly known in the art, examples of the phosphorus-based curing accelerator includes triphenylphosphine, and the like, examples of the amine-based curing accelerator include triethylamine, tributylamine, and the like, and examples of the imidazole-based curing accelerator include 2-methylimidazole, 2-phenylimidazole, 2-ethyl-4-methylimidazole, and the like, but are not particularly limited thereto. If necessary, one type of curing accelerator may be used alone, or two or more types thereof may be used in combination, and the content can be appropriately changed as long as it does not depart from the scope of the present invention.

In the present specification, the curing agent is a substance that is added to a curable resin to assist the curing reaction, and is classified into an active ester-based curing agent, a phenol-based curing agent, a cyanate ester-based curing agent, and the like, which are publicly known in the art, but is not particularly limited thereto. If necessary, one type of curing agent may be used alone, or two or more types may be used in combination, and the content can be appropriately changed as long as it does not depart from the scope of the present invention.

In the present specification, the polymerization initiator is a substance that generates radicals or (cationic) ions by a specific stimulus to initiate polymerization, and examples of the polymerization initiator publicly known in the art include dicumyl peroxide, t-butylcumyl peroxide, di-t-butyl peroxide, and the like, but are not particularly limited thereto. If necessary, one type of polymerization initiator may be used alone, or two or more types thereof may be used in combination, and the content can be appropriately changed as long as it does not depart from the scope of the present invention.

According to an exemplary embodiment of the present specification, the solvent may be applied without any particular limitation as long as it is publicly known to enable the formation of a curable resin composition in the art to which the present invention pertains. As a nonlimiting example, the solvent may be one or more compounds selected from the group consisting of esters, ethers, ketones, aromatic hydrocarbons, and sulfoxides.

The ester solvent may be ethyl acetate, n-butyl acetate, isobutyl acetate, amyl formate, isoamyl acetate, isobutyl acetate, butyl propionate, isopropyl butyrate, ethyl butyrate, butyl butyrate, methyl lactate, ethyl lactate, gamma-butyrolactone, epsilon-caprolactone, deltavalerolactone, alkyl oxyacetate (for example: methyl oxyacetate, ethyl oxyacetate, butyl oxyacetate (for example, methyl methoxyacetate, ethyl methoxyacetate, butyl methoxyacetate, methyl ethoxyacetate, ethyl ethoxyacetate, and the like)), 3-oxypropionic acid alkyl esters (for example: methyl 3-oxypropionate, ethyl 3-oxypropionate, and the like (for example, methyl 3-methoxypropionate, ethyl 3-methoxypropionate, methyl 3-ethoxypropionate, ethyl 3-ethoxypropionate, and the like)), 2-oxypropionic acid alkyl esters (for example: methyl 2-oxypropionate, ethyl 2-oxypropionate, propyl 2-oxypropionate, and the like (for example, methyl 2-methoxypropionate, ethyl 2-methoxypropionate, propyl 2-methoxypropionate, methyl 2-ethoxypropionate, ethyl 2-ethoxypropionate)), methyl 2-oxy-2-methylpropionate and ethyl 2-oxy-2-methylpropionate (for example, methyl 2-methoxy-2-methylpropionate, ethyl 2-ethoxy-2-methylpropionate, and the like), methyl pyruvate, ethyl pyruvate, propyl pyruvate, methyl acetoacetate, ethyl acetoacetate, methyl 2-oxobutanoate, ethyl 2-oxobutanoate, or the like.

The ether solvent may be diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, propylene glycol monopropyl ether acetate, or the like.

The ketone solvent may be methyl ethyl ketone (MEK), cyclohexanone, cyclopentanone, 2-heptanone, 3-heptanone, N-methyl-2-pyrrolidone, or the like.

The aromatic hydrocarbon solvent may be toluene, xylene, anisole, limonene, or the like.

The sulfoxide solvent may be dimethyl sulfoxide or the like.

According to an exemplary embodiment of the present specification, the curable resin composition further includes an additive, and the additive may be selected from the group consisting of a leveling agent, a wetting agent, an antistatic agent, and an antioxidant.

### <Insulating film>

Hereinafter, an insulating film including a curable resin composition according to an exemplary embodiment of the present specification or a cured product thereof will be described.

In the present specification, the cured product may be obtained by thermal curing.

In the present specification, the thermal curing may be performed under conditions and by a heating device, publicly known in the art, and for example, may be performed by curing and drying the cured product under the conditions of 100°C or higher for a predetermined time.

The insulating film according to an exemplary embodiment of the present specification may have a thickness of 5 µm or more, 10 µm or more, or 15 µm or more, and 40 µm or less, 35 µm or less, or 30 µm or less.

The insulating film according to an exemplary embodiment of the present specification may have a coefficient of linear thermal expansion of 25 ppm/°C or less, as measured in accordance with ASTM D696.

The insulating film according to an exemplary embodiment of the present specification may have a coefficient value of linear thermal expansion of 24 ppm/°C or less, or 22 ppm/°C or less and 0 ppm/°C or more, as measured in accordance with ASTM D696.

An insulating film having a coefficient of linear thermal expansion within the range as described above has almost no difference in expansion rate from a support in the future, so that deformation such as peeling or cracking does not occur.

The insulating film according to an exemplary embodiment of the present specification may have a dielectric constant (Dk) of 0 or more and 4.0 or less as measured at 10 GHz in accordance with ASTM D2520.

The insulating film according to an exemplary embodiment of the present specification may have a dielectric constant of 0.1 or more, 0.5 or more, or 1.0 or more, and 3.9 or less, 3.7 or less, or 3.5 or less as measured at 10 GHz in accordance with ASTM D2520.

An insulating film having the dielectric constants as described above may increase a signal transmission speed in the future.

The insulating film according to an exemplary embodiment of the present specification may have a dissipation factor (DF) of 0.001 or more and 0.004 or less as measured at 10 GHz in accordance with ASTM D2520.

The insulating film according to an exemplary embodiment of the present specification may have a dissipation factor of 0.0011 or more, 0.0012 or more, or 0.0013 or more, and 0.0039 or less, 0.0038 or less, or 0.0037 or less as measured at 10 GHz in accordance with ASTM D2520.

An insulating film having the dissipation factor as described above may minimize the loss of transmission signals in the future.

Since the above-described curable resin composition is used as it is or a cured product thereof is used for the insulating film, the contents on the curable resin composition may be applied.

### <Printed circuit board>

Hereinafter, a printed circuit board according to an exemplary embodiment of the present disclosure will be described.

Since the printed circuit board includes an insulating film in which the above-described curable resin composition is used as it is or a cured product thereof is used, the above-described contents on the curable resin composition may be applied.

### MODE FOR INVENTION

Hereinafter, the present specification will be described in detail with reference to Examples for specifically describing the present specification. However, the Examples according to the present specification may be modified in various forms, and it is not interpreted that the scope of the present specification is limited to the Examples described below. The Examples of the present specification are provided to more completely explain the present specification to a person with ordinary skill in the art.

### <Preparation Examples> Preparation of curable resin composition

### Preparation Example 1

After 5% by mass of maleimide compound A containing a diphenylmethane structure (BMI-5100, Daiwakasei Industry Co., Ltd.), 15% by mass of a radical polymerizable resin (OPE-2St, Mitsubishi Gas Chemical Company, Inc.), 10% by mass of a high-molecular weight resin containing a conjugated diene structure (1,2-H-SBS, Nippon Soda Co., Ltd.), and an inorganic filler (spherical silica, average particle diameter 0.5 µm, Admatechs SOC2) were added to a MEK (methyl ethyl ketone) solvent such that the content of the inorganic filler became 200 parts by mass based on 100 parts by mass of the entire solid content of the maleimide compound A containing a diphenylmethane structure, the radical polymerizable resin, and the high-molecular weight resin including a conjugated diene structure, the resulting mixture was stirred with a stirrer (250 rpm) for 3 hours to prepare curable resin composition 1.

### Preparation Example 2

Curable resin composition 2 was prepared in the same manner as in Preparation Example 1, except that the maleimide compound A containing a diphenylmethane structure (BMI-5100, Daiwakasei Industry Co., Ltd.) was changed to maleimide compound B containing a diphenylmethane structure (BMI-2300, Daiwakasei Industry Co., Ltd.).

### Preparation Example 3

Curable resin composition 3 was prepared in the same manner as in Preparation Example 1, except that the high-molecular weight resin containing a conjugated diene structure was changed from 1,2-H-SBS to 1,2-SBS-L42, and the content of the inorganic filler was also changed to the content shown in the following Table 1.

### Preparation Example 4

Curable resin composition 4 was prepared in the same manner as in Preparation Example 1, except that the content of the inorganic filler was changed to the content shown in the following Table 1.

### Comparative Preparation Example 1

Curable resin composition A was prepared in the same manner as in Preparation Example 1, except that the maleimide compound A containing a diphenylmethane structure (BMI-5100, Daiwakasei Industry Co., Ltd.) was changed to maleimide compound C containing a biphenyl structure (MIR-3000-70MT, Nippon Kayaku Co.,Ltd.).

### Comparative Preparation Example 2

Curable resin composition B was prepared in the same manner as in Preparation Example 1, except that the high-molecular weight resin containing a conjugated diene structure (1,2-H-SBS, Nippon Soda Co., Ltd.) was changed to a phenoxy resin (YX6954BH30, Mitsubishi Chemical Group Corporation).

### Comparative Preparation Example 3

Curable resin compositions C were each prepared in the same manner as in Preparation Example 1, except that the content of the inorganic filler was changed to the content shown in the following Table 1.

### Comparative Preparation Example 4

Curable resin composition D was each prepared in the same manner as in Preparation Example 1, except that the type of high-molecular weight resin containing a conjugated diene structure and the content of the inorganic filler were changed to the type and content shown in the following Table 1.

The compositions and contents (based on % by mass (solid content)) of the curable resin compositions of Preparation Examples 1 to 4 and Comparative Preparation Examples 1 to 4 are shown in the following Table 1.

**[Table 1]**

| No. | Classification | Type | Preparation Example 1 | Preparation Example 2 | Preparation Example 3 | Preparation Example 4 | Comparative Preparation Example 1 | Comparative Preparation Example 2 | Comparative Preparation Example 3 | Comparative Preparation Example 4 |
|---|---|---|---|---|---|---|---|---|---|---|
| 1 | (Maleimide compound (Containing | BMI-5100 | 5 | | 5 | 5 | | 5 | 5 | 5 |
| | | BMI-2300 | | 5 | | | | | | |
| | diphenylmethane structure) | | | | | | | | | |
| | Maleimide compound (Containing biphenyl structure) | MIR-3000-70MT | | | | | 5 | | | |
| 2 | Radical polymerizable resin | OPE-2St | 15 | 15 | 15 | 15 | 15 | 15 | 15 | 15 |
| 3 | High-molecular weight resin containing conjugated diene structure | 1,2-H-SBS | 10 | 10 | | 10 | 10 | | 10 | |
| | | 1,2-SBS-L42 | | | 10 | | | | | 10 |
| | Phenoxy resin | YX6954BH30 | | | | | | 10 | | |
| 4 | Inorganic filler | SOC2 | 60 | 60 | 70 | 90 | 60 | 60 | 54 | 150 |
| | Content (parts by mass) of inorganic filler based on 100 parts by mass of entire | | 200 | 200 | 230 | 300 | 200 | 200 | 180 | 500 |
| | solid content of 1+2+3 | | | | | | | | | |

### <Examples 1 to 4 and Comparative Examples 1 to 4> Preparation of insulating film

The curable resin compositions of Preparation Examples 1 to 4 and Comparative Preparation Examples 1 to 3 were each uniformly applied on a 40 µm PET film to a thickness of 20 µm, and then dried at 100°C for 5 minutes to prepare an insulating film having a thickness of 25 µm.

However, in the case of Comparative Preparation Example 4, the film coating surface was not uniformly formed due to insufficient wetting property and the curable resin composition could not be formed into a film, so that Comparative Preparation Example 4 was not evaluated in the following Experimental Examples.

### <Experimental Examples>

### 1) Preparation of sample

The insulating films of Examples 1 to 4 and Comparative Examples 1 to 3 were each thermally cured by heating at 200°C for 90 minutes, and a PET film as a support was peeled off to obtain cured samples.

### 2) Experimental Example 1: Evaluation of dielectric characteristics

The dielectric constants and dissipation factors of the cured samples (thickness 100 µm) obtained from the Examples 1 to 4 and Comparative Examples 1 to 3 were measured at 10 GHz using E5071C equipment manufactured by Agilent Technologies, Inc., under the conditions of a measurement temperature of 20 to 25°C and a humidity of 50% or less. The measurement results are shown in the following Table 2.

### 3) Experimental Example 2: Evaluation of coefficient of linear thermal expansion

The cured samples obtained from Examples 1 to 4 and Comparative Examples 1 to 3 were cut into test specimens with a width of about 5 mm and a length of about 15 mm, and measured twice consecutively using a TMA (Q400 manufactured by TA Instruments) under the following measurement conditions: a heating rate of 10°C/min and 0°C to 300°C. In the second measurement, an average coefficient of linear thermal expansion (ppm/°C) from 25°C to 120°C was determined. The measurement results are shown in the following Table 2.

### 4) Experimental Example 3: Evaluation of brittleness

When the cured samples obtained from the above Examples 1 to 4 and Comparative Examples 1 to 3 were bent by 90°, the number of times when the cured samples were cracked or broken was measured. The measurement criteria are as follows, and the measurement results are shown in the following Table 2.
∘: The samples were broken once or less when bent 10 times (good)
△: The samples were broken two to four times when bent 10 times (fair)
×: The samples were broken five times or more when bent 10 times (poor)

**[Table 2]**

| Experimental Example No. | Example 1 | Example 2 | Example 3 | Example 4 | Comparative Example 1 | Comparative Example 2 | Comparative Example 3 | Comparative Example 4 |
|---|---|---|---|---|---|---|---|---|
| Dielectric constant (10 GHz) | 3.1 | 3.1 | 3.0 | 3.2 | 3.2 | 3.1 | 3.2 | Cannot be measured |
| Dissipation factor (10 GHz) | 0.0016 | 0.0017 | 0.0019 | 0.0025 | 0.0025 | 0.013 | 0.0020 | Cannot be measured |
| Coefficient of linear thermal expansion (ppm/°C) | 18 | 22 | 15 | 17 | 17 | Not measurable | 27 | Cannot be measured |
| Brittleness | ○ | ○ | ○ | ○ | Δ | X | ○ | Cannot be measured |

According to Table 2 above, Examples 1 to 4 were all excellent in terms of dielectric constant, dissipation factor, coefficient of linear thermal expansion, and brittleness, and thus, were suitable for use in an insulating film. In contrast, it was confirmed that Comparative Example 1 had a slightly higher dissipation factor than the Examples, an excellent coefficient of linear thermal expansion, but poor brittleness, and since Comparative Example 2 had a very high dissipation factor and poor brittleness, even the coefficient of linear thermal expansion was not measured, and although Comparative Example 3 had improved brittleness, Comparative Example 3 was not suitable for use in an insulating film because both the dissipation factor and the coefficient of linear thermal expansion of Comparative Example 3 were higher than those of the Examples. Since Comparative Example 4 was not formed into a film, the dielectric characteristics, coefficient of linear thermal expansion, and brittleness to be measured based on a film could not be measured.

## Claims

1. A curable resin composition comprising:
a maleimide compound comprising a diphenylmethane structure;
a radical polymerizable resin;
a high-molecular weight resin comprising a conjugated diene structure; and
an inorganic filler,
wherein the inorganic filler is comprised in an amount of 200 parts by mass or more and 400 parts by mass or less based on 100 parts by mass of the entire solid content of the maleimide compound comprising a diphenylmethane structure; the radical polymerizable resin; and the high-molecular weight resin comprising a conjugated diene structure.

2. The curable resin composition of claim 1, wherein the maleimide compound comprising a diphenylmethane structure is represented by the following Chemical Formula 1: 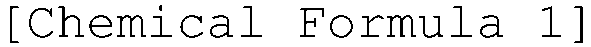 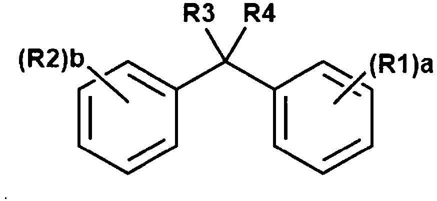 in Chemical Formula 1,
R1 to R4 are the same as or different from each other, and are each independently hydrogen; an alkyl group; an aryl group; a heteroaryl group; or a substituent represented by the following Chemical Formula 2, and at least one thereof is a substituent represented by the following Chemical Formula 2,
a and b are the same as or different from each other, and are each independently an integer from 0 to 5, and when each of a and b is an integer of 2 or higher, substituents in the parenthesis are the same as or different from each other, 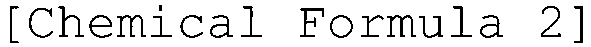 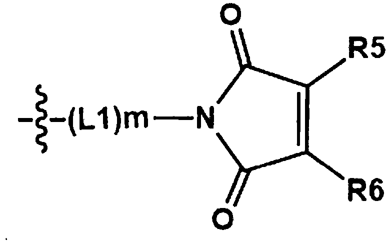 in Chemical Formula 2, 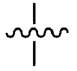
means a bond to Chemical Formula 1,
L1 is a direct bond; an alkylene group; an arylene group; or a heteroarylene group,
R5 and R6 are the same as or different from each other, and are each independently hydrogen; an alkyl group; an aryl group; or a heteroaryl group, and
m is an integer from 0 to 4.

3. The curable resin composition of claim 1, wherein the radical polymerizable resin comprises an unsaturated group, and
the unsaturated group is selected from the group consisting of a (meth)acrylate group, a (meth)acrylamide group, salts of organic acids, a vinyl ether group, an allyl ether group, a vinyl ester group, a styrene group, a vinyl group, and an allyl ester group.

4. The curable resin composition of claim 1, wherein the high-molecular weight resin comprising a conjugated diene structure comprises a unit represented by the following Chemical Formula 3 in at least one of a main chain and a side chain: 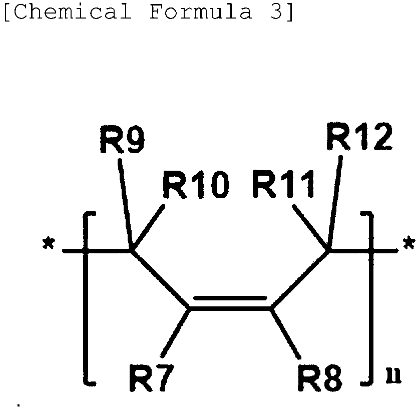 in Chemical Formula 3,
* is a position linked to another unit,
R7 to R12 are the same as or different from each other, and are each independently hydrogen; an alkyl group; an aryl group; or a heteroaryl group, and
n is 90 or more and 4000 or less.

5. The curable resin composition of claim 1, wherein the high-molecular weight resin comprising a conjugated diene structure has a weight average molecular weight MW of 4,000 g/mol or more and 200,000 g/mol or less.

6. The curable resin composition of claim 1, wherein the inorganic filler has an average particle diameter of 1.0 µm or less.

7. The curable resin composition of claim 1, further comprising an additive and a solvent,
wherein the additive is selected from the group consisting of a leveling agent, a wetting agent, an antistatic agent, a flame retardant, a crosslinking agent, a curing accelerator, a curing agent, and a polymerization initiator.

8. An insulating film comprising the curable resin composition according to any one of claims 1 to 7 or a cured product thereof.

9. The insulating film of claim 8, wherein a coefficient value of linear thermal expansion as measured in accordance with ASTM D696 is 25 ppm/°C or less.

10. The insulating film of claim 8, wherein a dissipation factor DF as measured at 10 GHz in accordance with ASTM D2520 is 0.001 or more and 0.004 or less.

11. A printed circuit board comprising the insulating film according to claim 8.
